# EUROPÄISCHE PATENTSCHRIFT

(11) **EP 0 513 536 B1**
(45) Veröffentlichungstag und Bekanntmachung des Hinweises auf die Patenterteilung: **14.08.1996**
(21) Anmeldenummer: 92106401.0
(22) Anmeldetag: 14.04.1992
(51) Int. Cl.: C07F 9/6571, G03C 1/73

(54) **Cyclische Acylphosphinsäurederivate und Verfahren zu ihrer Herstellung**
Cyclic acylphosphinic acid derivatives and process for their preparation
Dérivés cycliques d'acides acylphosphiniques et procédé pour leur préparation

(30) Priorität: 16.05.1991 DE 4115946
(43) Veröffentlichungstag der Anmeldung: 19.11.1992
(73) Patentinhaber: HOECHST AKTIENGESELLSCHAFT, 65926 Frankfurt am Main (DE)
(72) Erfinder: Svara, Jürgen, Dr., W-5000 Köln 50 (DE)

(56) Entgegenhaltungen:
- EP-A- 0 304 782

## Beschreibung

Die Erfindung betrifft neue cyclische Acylphosphinsäurederivate der Formel 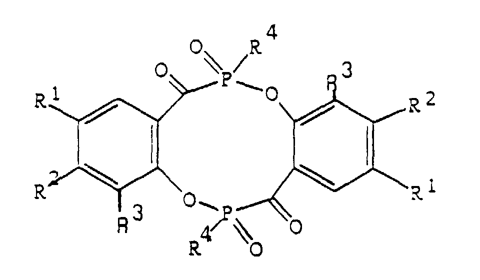 worin die Substituenten unabhängig voneinander folgende Bedeutung haben können:
R¹, R², R³ = H, Halogen, C1- bis C10-Alkyl oder -Alkoxy, Phenyl, Phenoxy, Acetyl oder NO₂, wobei R¹ und R² zusammen, unter Einbeziehung des zugehörigen aromatischen 6-Rings, auch ein erweitertes, gegebenenfalls substituiertes, aromatisches Ringsystem bilden können;
R⁴ = C1- bis C4-Alkyl, C5- oder C6-Cycloalkyl, Phenyl oder Alkylphenyl.
Die Substituenten R¹ und R² können zusammen z.B. eine Benzo-Gruppe bilden, d.h. der vorhandene aromatische Benzolkörper wird zum aromatischen Naphthalinkörper erweitert. Als möglicher Substituent in diesem erweiterten aromatischen Ringsystem kann z.B. die Methoxygruppe dienen (vgl. Beispiel 16).

Bevorzugt sind cyclische Acylphosphinsäurederivate der obengenannten Formel, worin die Substituenten unabhängig voneinander folgende Bedeutung haben können:
R¹, R², R³ = H, Cl, Br, CH₃, CH₃O, CH₃CO oder NO₂, wobei R¹ und R² zusammen, unter Einbeziehung des zugehörigen aromatischen 6-Rings, auch eine ggf. durch eine Methoxygruppe substituierte Naphthalinstruktur bilden können;
R⁴ = Methyl, sek. Butyl oder Phenyl.

Die neuen cyclischen Acylphosphinsäurederivate sind als Photoinitiatoren einsetzbar.

Die Erfindung betrifft weiterhin auch ein Verfahren zur Herstellung der genannten neuen cyclischen Acylphosphinsäurederivate, welches dadurch gekennzeichnet ist, daß man aromatische o-Hydroxycarbonsäuren der Formel 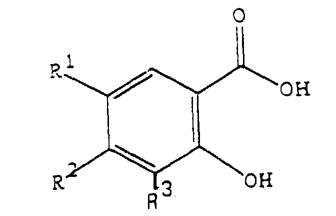 oder deren Alkalimetallsalze mit Organyldichlorphosphanen der Formel R⁴PCl₂, wobei R¹, R², R³ und R⁴ die angegebene Bedeutung besitzen, in einem aprotischen Löse- oder Suspendiermittel bei Temperaturen von 0 bis 2oo°C, vorzugsweise 2o bis 15o°C, unter Freisetzung gasförmigen Chlorwasserstoffs bzw. Abscheidung von Alkalichlorid umsetzt und das ausgefallene Zielprodukt abtrennt, wäscht und trocknet.

Aprotische Löse- bzw. Suspendiermittel sind solche, die sich gegenüber einer P-Cl-Gruppe und HCl inert verhalten, z.B. Toluol, Xylol, halogenierte Kohlenwasserstoffe, Petrolether, Alkane, Ether (Methyl-tert.-butylether, Diisopropylether, Glycolether) oder Ether-Ester des Glycols (z.B. Methylglycolacetat). Die einzusetzenden aprotischen Löse- bzw. Suspendiermittel müssen selbstverständlich einen Siedepunkt aufweisen, der oberhalb der gewählten Umsetzungstemperatur liegt oder ihr gerade entspricht. Als Alkalimetallsalze der einzusetzenden aromatischen o-Hydroxycarbonsäurederivate kommen bevorzugt die Natrium- und Kaliumsalze in Frage.

Die Ausgangsstoffe werden im allgemeinen in stöchiometrischen Gewichtsverhältnissen, d.h. in gleichen molaren Mengen (1 : 1) eingesetzt, doch sind Molverhältnisse von 1 : 2 bis 2 : 1 möglich.

Hinsichtlich der Umsetzungstemperatur wird eine Arbeitsweise unter Rückfluß des Löse- bzw. Suspendiermittels bevorzugt.

Die erfindungsgemäße Umsetzung kann in Gegenwart katalytischer Mengen heterocyclischer, aromatischer Verbindungen oder quartärer Ammonium- oder Phosphoniumsalze durchgeführt werden, welche die Reaktion von P-Cl-Gruppen mit OH-Gruppen beschleunigen. Beispielsweise eignen sich Pyridine, vorzugsweise Dimethylaminopyridine, Chinoline oder Imidazole als Katalysatoren. Im Falle der Verwendung eines Katalysators kann dieser in Mengen von 0,1 bis 10 Mol%,
berechnet auf die eingesetzte aromatische o-Hydroxycarbonsäure, zugeführt werden. Im Gegensatz dazu ist die Zugabe eines säurebindenden Mittels, z.B. eines tertiären Amins, in etwa stöchiometrischem Molverhältnis zum Abfangen des Chlorwasserstoffs im Reaktionsgemisch nicht vorteilhaft, da sich in diesem Fall wie erwartet Verbindungen mit 6-Ring-Struktur vom Typus 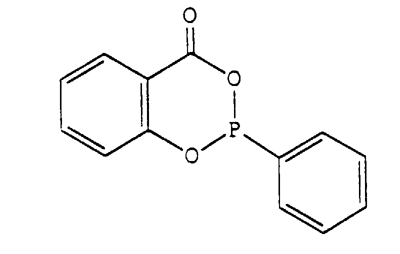 bilden.

Die Umsetzungstemperatur wird in der Regel in Abhängigkeit von der Reaktivität der Einsatzstoffe gewählt. Die Reaktionsdauer ist von untergeordneter Bedeutung und im allgemeinen kürzer, wenn die Umsetzungstemperatur hoch ist. Die Reaktionsdauer kann zwischen 1 und 75 Stunden liegen.

Die Aufarbeitung der Zielprodukte erfolgt nach Standardmethoden der präparativen organischen Chemie. Häufig sind die Zielprodukte kristallin und werden durch Filtration isoliert, ggf. nach Einengen oder Abkühlen der Reaktionsmischung.

Beim Einsatz von Alkalisalzen der aromatischen o-Hydroxycarbonsäuren muß das entstehende Alkalimetallchlorid entweder durch Filtration oder durch Waschen des Reaktionsgemischs oder des abgetrennten Rohprodukts mit Wasser entfernt werden.

### Beispiel 1) Umsetzung von Salicylsäure mit Phenyldichlorphoaphan PhPCl₂

Zu einer Suspension von Salicylsäure (28,7 g; 208 mmol) in Xylol (100 ml) tropft man Phenyldichlorphosphan (37,1 g; 208 mmol). Beim Erwärmen setzt HCl-Entwicklung ein und die Lösung färbt sich gelb. Die Salicylsäure geht unter gleichmäßiger Gasentwicklung langsam in Lösung. Das Reaktionsgemisch wird 72 h bei 75°C gerührt, wobei sich ein kristalliner Feststoff abscheidet. Nach Abkühlen wird der ausgefallene Feststoff abgesaugt, mit Toluol gewaschen und im Vakuum getrocknet. Man erhält ein feinkristallines, farbloses Pulver.

### Formel:

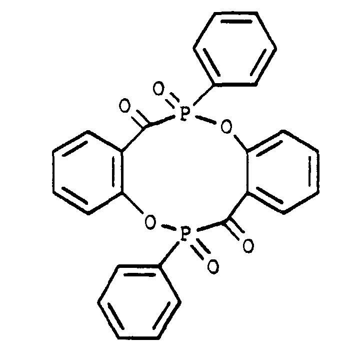

Name: 7,14-Dioxo-6,13-diphenyl-dibenzo[d,i]-1,6-dioxa-2,7-diphosphecan-6,13-dioxid
Ausbeute: 31,5 g (62,3 % d. Th.)
Schmelzpunkt: 250°C
NMR-Daten:
³¹P (CDCl₃ ): 31,0 ppm;
¹H (80 MHz, CDCl₃): 6,8-8,0 ppm (Multiplett)
¹³C (100 MHz, CDCl₃):
   146,8 ppm; Multiplett; C=O;
   135,8 ppm; Multiplett; C-O;
   133,6 ppm; Singulett; C-H (Benzo-);
   131,7 ppm; Multiplett; C-H (P-Phenyl);
   131,3 ppm; Singulett; C-H (Benzo-);
   128,4 ppm; Multiplett; C-H (P-Phenyl);
   128,0 ppm; Singulett; C-H (P-Phenyl);
   125,8 ppm; Singulett; C-H (Benzo-);
   124,3 ppm; Dublett; ¹J(C-P)=188,2Hz; (P-Phenyl);
   123,8 ppm; Singulett (breit); C-CO;
   121,6 ppm; Singulett; CH-C-O;
   MS (Direkteinlaß, 70 eV): m/e (Iᵣₑₗ, Fragment):
   488 (100, M⁺);
   348 (16, M-PhPO₂┐⁺);
   Hochauflösung gef. (ber.): 488,0578 (488,057866)
UV (Acetonitril): Maximum bei 283 nm;

### Beispiel 2) Umsetzung von Salicylsäure mit Phenyldichlorphosphan PhPCl₂

Wie in Beispiel 1 wird Salicylsäure (600 g; 4,4 mol) in Methylglycolacetat (1100 ml) während 5 h bei 140°C mit PhPCl₂ (778 g; 4,4 mol) umgesetzt. Nach Abkühlen und Aufarbeitung erhält man einen farblosen bis schwachgelben, kristallinen Feststoff.
Ausbeute: 456 g (41,1 % d. Th.)
³¹P-NMR (CDCl₃): 30,5 ppm

### Beispiel 3) Umsetzung von salicylsäure mit Phenyldichlorphosphan PhPCl₂

Analog Beispiel 1 bringt man Salicylsäure (69 g; 0,5 mol) mit PhPCl₂ (89,5 g; 0,5 mol) während 24 h bei 115 °C in Toluol zur Reaktion.
Ausbeute: 40 g (32,5 % d. Th.)
³¹P-NMR (CDCl₃): 30,9 ppm

### Beispiel 4) Umsetzung von Natrium-salicylat mit Phenyldichlorphosphan PhPCl₂

Man setzt in Toluol (120 ml) Natriumsalicylat (84,7 g, 529 mmol) mit PhPCl₂ (94,7 g, 529 mmol) um (Temperatur: 110°C; Reaktionszeit: 7 h). Der ausgefallene Feststoff wird abgetrennt, mit Wasser aufgeschlämmt und nochmals abfiltriert. Nach weiterem Waschen mit Wasser zur Entfernung von NaCl und Trocknen erhält man ein kristallines, noch etwas verunreinigtes Produkt.
Ausbeute: 82,7 g (64 % d. Th.); nach Umkristallisieren aus wasserfreier Essigsäure: 45 g (34,8 % d. Th.)
³¹P-NMR (CDCl₃): 31,0 ppm

### Beispiel 5) Umsetzung von Salicylsäure mit Methyldichlorphosphan

Zu einer Suspension von Salicylsäure (80 g; 0,58 mol) in Toluol (100 ml) tropft man bei 100°C Methyldichlorphosphan (68 g; 0,58 mol). Es setzt sofort starke HCl-Entwicklung ein und die Lösung färbt sich gelb. Die Salicylsäure geht unter gleichmäßiger Gasentwicklung in Lösung. Das Reaktionsgemisch wird 4 h bei 110°C gerührt, wobei sich ein kristalliner Feststoff abscheidet. Nach Abkühlen wird der ausgefallene Feststoff abgesaugt, mit Toluol gewaschen und getrocknet. Man erhält ein feinkristallines, farbloses Pulver.

### Formel:

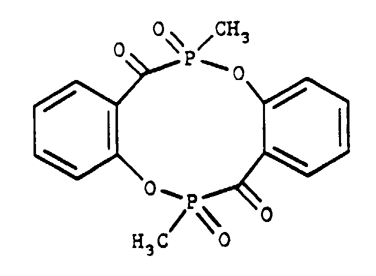

Name: 7,14-Dioxo-6,13-dimethyl-dibenzo[d,i]-1,6-dioxa-2,7-diphosphecan-6,13-dioxid
Ausbeute: 18 g (17 % d. Th.)
Schmelzpunkt: 276°C
NMR-Daten:
³¹P (CDCl₃): 43,9/44,2 ppm (2 Isomere);
¹H (80 MHz, CDCl₃):
   1,66 ppm (¹J_{p-C}= 17,9 Hz) (Isomer 1)
   1,75 ppm (¹J_{P-C}= 17,6 Hz) (Isomer 2)
   7,2-8,1 ppm, Multiplett
UV (Acetonitril): Maximum: 281 nm;

### Beispiel 6) Umsetzung von Salicylsäure mit Methyldichlorphosphan

Die Umsetzung nach Beispiel 5 wird mit 232 g (1,7 mol) Salicylsäure und 197 g (1,7 mol) Methyldichlorphosphan in Toluol (400 ml) wiederholt, wobei man als Katalysator 4-Dimethylaminopyridin DMAP (5 g; 41 mmol) zusetzt. Es setzt sofort eine heftige Chlorwasserstoffentwicklung ein. Die Reaktion ist nach 30 Minuten beendet.
Ausbeute: 79,5 g (25,9 % d. Th.)
³¹P-NMR (CDCl₃) 45,5/45,7 ppm

### Beispiel 7) Umsetzung von 4-Chlorsalicylsäure mit Phenyldichlorphosphan PhPCl₂

Wie in Beispiel 1 setzt man 4-Chlorsalicylsäure (81,3 g; 471 mmol) in Toluol (170 ml) mit Phenyldichlorphosphan (84,3 g; 471 mmol) während 7 h bei 110°C um. Gegen Ende der Reaktion fällt aus dem hellbraunen Reaktionsgemisch ein feiner Feststoff aus. Man läßt über Nacht erkalten, saugt den Feststoff ab und wäscht 2 mal mit wenig Toluol. Reinigung durch nochmaliges Aufschlämmen in Toluol, Absaugen und Trocknen im Vakuum.

### Formel:

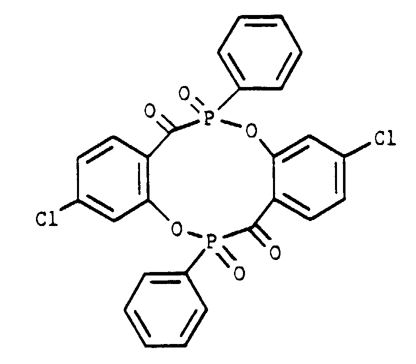

Name: 3,10-Dichlor-7,14-dioxo-6,13-diphenyl-dibenzo-[d,i]-1,6-dioxa-2,7-diphosphecan-6,13-dioxid
Ausbeute: 77,4 g (59,0% d. Th.)
Schmelzpunkt: 243-245°C
NMR-Daten:
³¹P (CDCl₃ ): 31,5 ppm;
¹H (80 MHz, CDCl₃): 6,9-8,0 ppm (Multiplett);
¹³C (20,1 MHz, CDCl₃):
   147,3 ppm; Multiplett; C=O;
   137,2 ppm; Singulett; C-Cl;
   135,9 ppm; Multiplett; C-O;
   134,1 ppm; Singulett; C-H (Benzo);
   131,8 ppm; Multiplett; C-H (P-Phenyl);
   129,0 ppm; Multiplett; C-H (P-Phenyl);
   128,8 ppm; Singulett; C-H (P-Phenyl);
   126,5 ppm; Singulett; C-H (Benzo);
   andere Peaks nicht zugeordnet;
UV (Acetonitril): Maximum bei 296 nm;

### Beispiel 8) Umsetzung von 5-Chlorsalicylsäure mit Phenyldichlorphosphan

Wie in Beispiel 1 setzt man 5-Chlorsalicylsäure (87,5 g; 507 mmol) in Toluol (170 ml) mit Phenyldichlorphosphan (90,8 g; 507 mmol) während 7 h bei 110°C um. Gegen Ende der Reaktion fällt aus dem gelben Reaktionsgemisch ein feiner Feststoff aus. Man läßt über Nacht erkalten, saugt den Feststoff ab, wäscht mehrere Male mit wenig Toluol und trocknet im Vakuum.

### Formel:

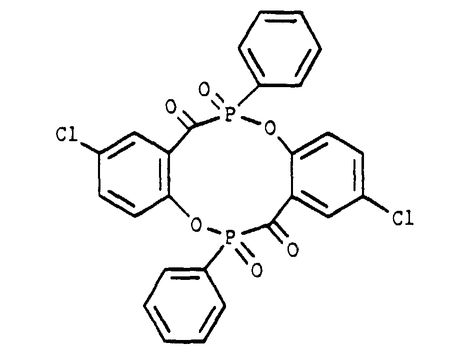

Name: 2,9-Dichlor-7,14-dioxo-6,13-diphenyl-dibenzo-[d,i]-1,6-dioxa-2,7-diphosphecan-6,13-dioxid
Ausbeute: 112,2 g (79,4 % d. Th.)
Schmelzpunkt: 276-278°C
NMR-Daten: ³¹P (CDCl₃ ): 30,2 ppm;
UV (Acetonitril): Maximum bei 281 nm;

### Beispiel 9-14: siehe Tabellen 1 und 2

### Beispiel 15: Umsetzung von 3-Hydroxy-2-naphthoesäure mit Phenyldichlorphosphan

Wie in Beispiel 1 beschrieben setzt man 3-Hydroxy-2-naphthoesäure (176 g; 935 mmol) in Methylglycolacetat (200 ml) zuerst 5 h bei 155 °C und dann 15 h bei 100 °C mit Phenyldichlorphosphan (167,4 g; 935 mmol) um. Dabei fällt ein feiner Feststoff aus, der abgetrennt und durch mehrmaliges Aufschlämmen in Toluol und Filtrieren gereinigt wird. Die Trocknung erfolgt im Vakuum.

### Formel:

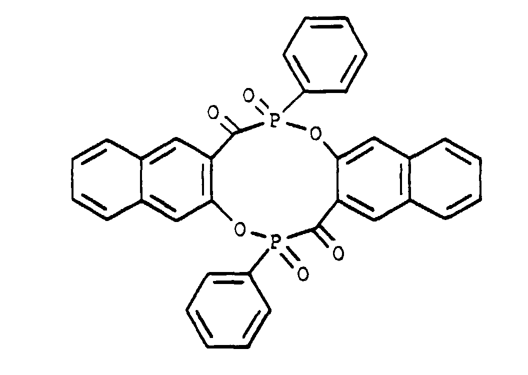

Name: 8,17-Dioxo-7,16-diphenyl-dinaphtho[2,3-d:2',3'-i]-1,6-dioxa-2,7-diphosphecan-7,16-dioxid
Ausbeute: 146,2g (54,1 % d. Th.)
Schmelzpunkt: 280-283°C
NMR-Daten:
³¹P (81 MHz; CDCl₃ ): 28,0 ppm;
¹H (400 MHz, CDCl₃): 7,34-8,57 ppm (Multiplett)
¹³C (100 MHz, CDCl₃):
   143,7 ppm; Multiplett; C=O;
   136,5 ppm; Multiplett; C-O;
   134,2 ppm; Singulett; C (Naphtho);
   134,0 ppm; Singulett; C-H (Naphtho-);
   132,1 ppm; Multiplett; C-H (P-Phenyl);
   130,8 ppm; Singulett; C (Naphtho-);
   129,4 ppm; Singulett; C-H (Naphtho);
   128,9 ppm; Multiplett; C-H (P-Phenyl);
   128,7 ppm; Singulett; C-H (Naphtho-);
   128,2 ppm; Singulett; C-H (P-Phenyl);
   127,4 ppm; Singulett; C-H (Naphtho-);
   126,6 ppm; Singulett; C-H (Naphtho-);
   124,8 ppm; Dublett; ¹J(C-P)=188,3 Hz;(P-Phenyl);
   123,4 ppm; Singulett; C-CO;
   119,1 ppm; Singulett; CH-C-O;
MS (Direkteinlaß, 70 eV): m/e (Iᵣₑₗ, Fragment):
588 (100, M⁺);
448 (17, M-PhPO₂┐⁺);
Hochauflösung gef. (ber.): 588,0891 (588,089166)
UV (Acetonitril): Maxima bei 324 und 270 nm;

### Beispiel 16: Umsetzung von 6-Methozy-3-hydrozy-2-naphthoesäure mit Phenyldichlorphosphan

Analog Beispiel 15 setzt man technische 3-Hydroxy-6-methoxy-2-naphthoesäure (100 g; 458 mmol) in Toluol (200 ml) 8 Stunden bei 110°C mit Phenyldichlorphosphan (81,9 g; 458 mmol) um. Man isoliert ein hellbraunes, noch etwas verunreinigtes, kristallines Produkt.

### Formel:

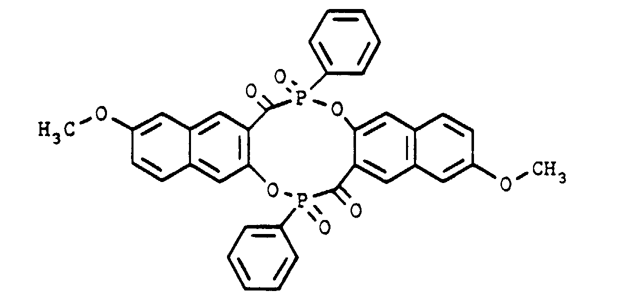

Name: 2,11-Dimethoxy-8,17-dioxo-7,16-diphenyl-dinaphtho-[2,3-d:2',3'-i]-1,6-dioxa-2,7-diphosphecan-7,16-dioxid
Ausbeute: 88 g (29,6 % d. Th.)
Schmelzpunkt: >300°C
NMR-Daten: ³¹P (CDCl₃ ): 30,6 ppm;
UV (Acetonitril): Maxima bei 269 und 323 nm

### Beispiel 17: Umsetzung von 3-Hydroxy-2-naphthoesäure mit Methyldichlorphosphan

Wie in Beispiel 15 beschrieben setzt man 3-Hydroxy-2-naphthoesäure (300 g; 1596 mmol) in Toluol (300 ml) während 5 h bei 110 °C mit Methyldichlorphosphan (185,1 g; 1596 mmol) um. Man erhält einen feinkristallinen, farblosen Feststoff.

### Formel:

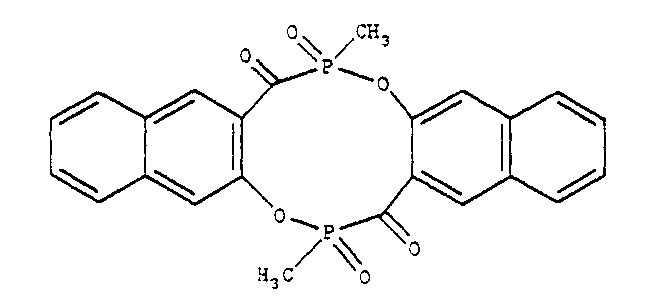

Name: 8,17-Dioxo-7,16-dimethyl-dinaphtho[2,3-d:2',3'-i]-1,6-dioxa-2,7-diphosphecan-7,16-dioxid
Ausbeute: 71,4g (19,2 % d. Th.)
Schmelzpunkt: 271-280°C
NMR-Daten: ³¹P (CDCl₃ ): 46,0 ppm;
UV (Acetonitril): Maxima bei 269 und 322 nm

### Beispiel 18: Umsetzung von 3-Hydroxy-2-naphthoesäure mit s-Butyldichlorphosphan

Wie in Beispiel 15 beschrieben setzt man 3-Hydroxy-2-naphthoesäure (47,3 g; 252 mmol) in Toluol (115 ml) während 6 h bei 110 °C mit s-Butyldichlorphosphan (40,0 g; 252 mmol) um. Man erhält einen feinkristallinen, farblosen Feststoff.

### Formel:

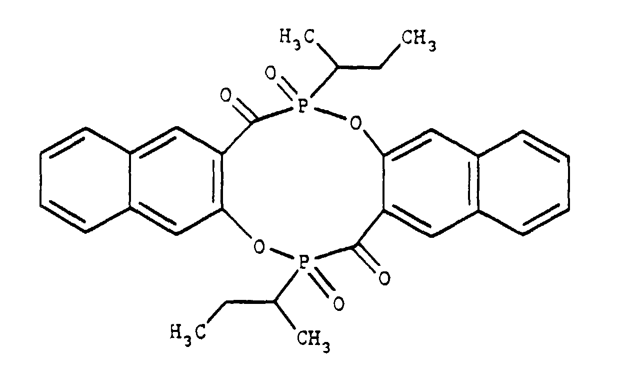

Name: 8,17-Dioxo-7,16-bis(1-methylpropyl)-dinaphtho-[2,3-d:2',3'-i]-1,6-dioxa-2,7-diphosphecan-7,16-dioxid
Ausbeute: 25,8 g (37,4 % d. Th.)
Schmelzpunkt: 238°C
NMR-Daten: ³¹P (CDCl₃ ): 47,2-47,7 ppm (mehrere Isomere);
UV (Acetonitril): Maxima bei 270 und 323 nm

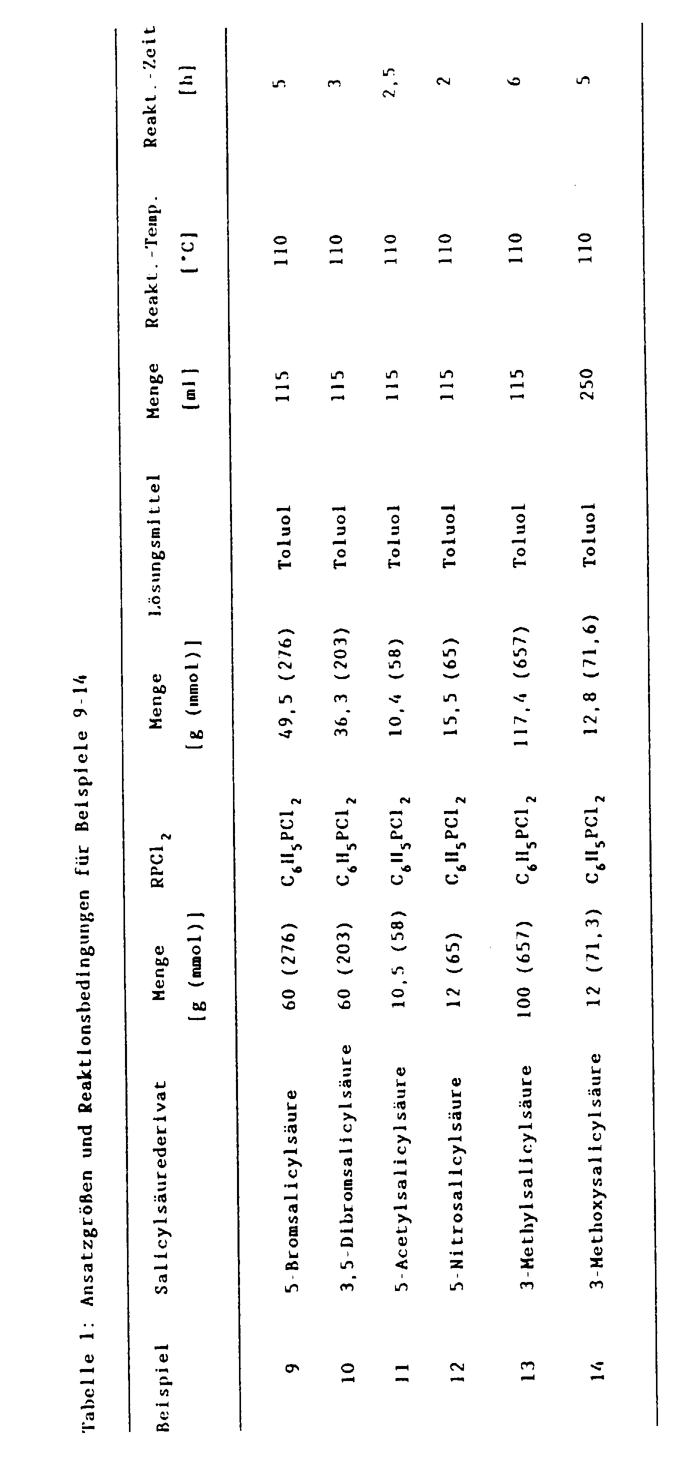

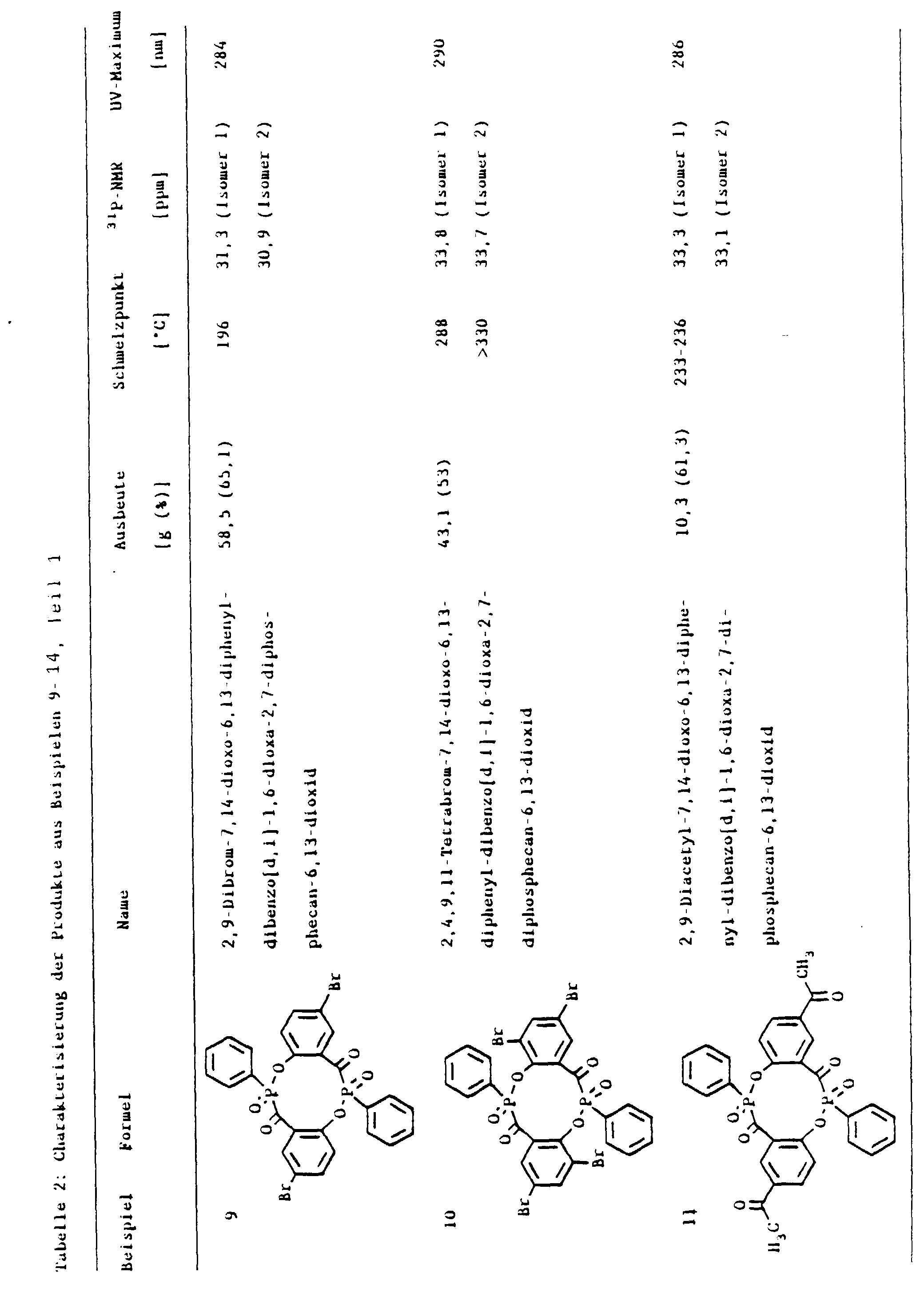

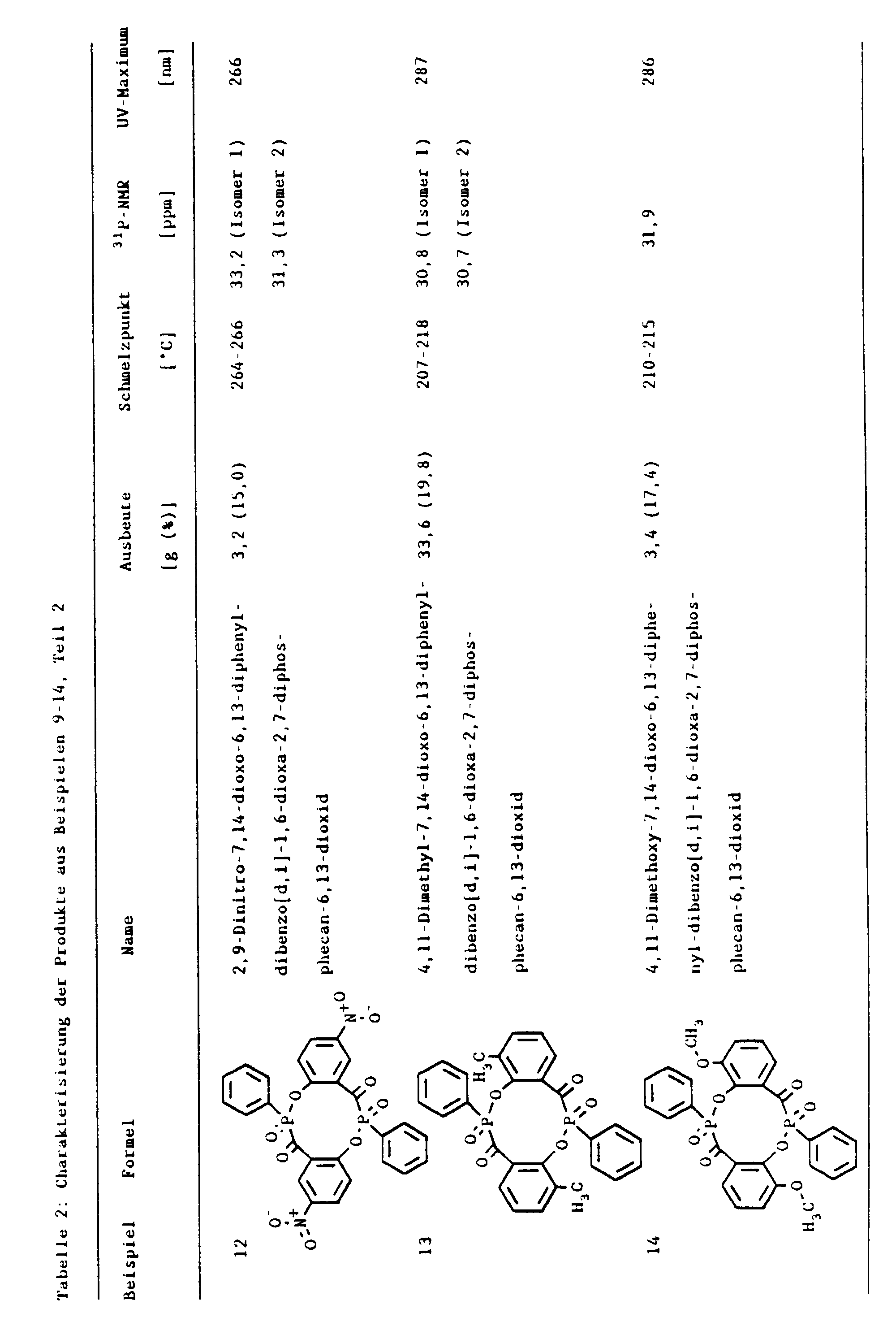

## Patentansprüche (Patentansprüche für folgende(n) Vertragsstaat(en): AT, BE, CH, DE, FR, GB, IT, LI, NL)

1. Cyclische Acylphosphinsäurederivate der Formel 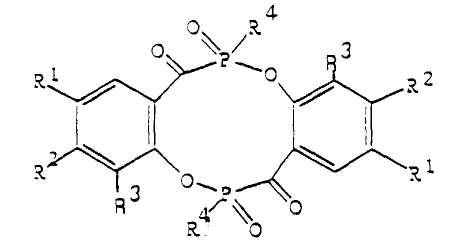 worin die Substituenten unabhängig voneinander folgende Bedeutung haben:
R¹, R², R³ = H, Halogen, C1- bis C10-Alkyl oder -Alkoxy, Phenyl, Phenoxy, Acetyl oder NO₂, wobei R¹ und R² zusammen, unter Einbeziehung des zugehörigen aromatischen 6-Rings, auch ein erweitertes, gegebenenfalls substituiertes, aromatisches Ringsystem bilden können;
R⁴ = C1- bis C4-Alkyl, C5- oder C6-Cycloalkyl, Phenyl oder Alkylphenyl.

2. Cyclische Acylphosphinsäurederivate der Formel gemäß Anspruch 1, worin die Substituenten unabhängig voneinander folgende Bedeutung haben:
R¹, R², R³ = H, Cl, Br, CH₃, CH₃O, CH₃CO oder NO₂, wobei R¹ und R² zusammen, unter Einbeziehung des zugehörigen aromatischen 6-Rings, auch eine ggf. durch eine Methoxygruppe substituierte Naphthalinstruktur bilden können; R⁴ = Methyl, sek. Butyl oder Phenyl.

3. Verfahren zur Herstellung der cyclischen Acylphosphinsäurederivate gemäß Anspruch 1 oder 2, dadurch gekennzeichnet, daß man aromatische o-Hydroxycarbonsäuren der Formel 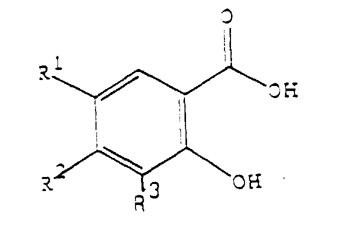 oder deren Alkalimetallsalze mit Organyldichlorphosphanen der Formel R⁴PCl₂, wobei R¹, R², R³ und R⁴ die angegebene Bedeutung besitzen, in einem aprotischen Löse- oder Suspendiermittel bei Temperaturen von 0 bis 2oo°C, vorzugsweise 2o bis 15o°C, unter Freisetzung gasförmigen Chlorwasserstoffs bzw. Abscheidung von Alkalichlorid umsetzt und das ausgefallene Zielprodukt abtrennt, wäscht und trocknet.

4. Verfahren gemäß Anspruch 3, dadurch gekennzeichnet, daß man die Umsetzung in Gegenwart katalytischer Mengen heterocyclischer, aromatischer Verbindungen oder quartärer Ammonium- oder Phosphoniumsalze durchführt.

## Patentansprüche (Patentansprüche für folgende(n) Vertragsstaat(en): ES)

1. Verfahren zur Herstellung cyclischer Acylphosphinsäurederivate der Formel 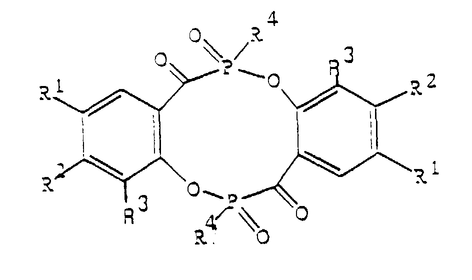 worin die Substituenten unabhängig voneinander folgende Bedeutung haben:
R¹, R², R³ = H, Halogen, C1- bis C10-Alkyl oder -Alkoxy, Phenyl, Phenoxy, Acetyl oder NO₂, wobei R¹ und R² zusammen, unter Einbeziehung des zugehörigen aromatischen 6-Rings, auch ein erweitertes, gegebenenfalls substituiertes, aromatisches Ringsystem bilden können:
R⁴ = C1- bis C4-Alkyl, C5- oder C6-Cycloalkyl, Phenyl oder Alkylphenyl; dadurch gekennzeichnet, daß man aromatische o-Hydroxycarbonsäuren der Formel 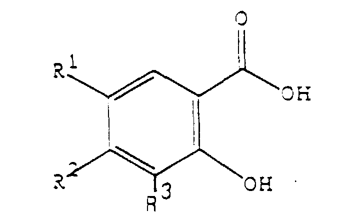 oder deren Alkalimetallsalze mit Organyldichlorphosphanen der Formel H⁴PCl₂, wobei R¹, R², R³ und R⁴ die angegebene Bedeutung besitzen, in einem aprotischen Löse- oder Suspendiermittel bei Temperaturen von 0 bis 2oo °C, vorzugsweise 2o bis 15o °C, unter Freisetzung gasförmigen Chlorwasserstoffs bzw. Abscheidung von Alkalichlorid umsetzt und das ausgefallene Zielprodukt abtrennt, wäscht und trocknet.

2. Verfahren gemäß Anspruch 1, dadurch gekennzeichnet, daß man die Umsetzung in Gegenwart katalytischer Mengen heterocyclischer, aromatischer Verbindungen oder quartärer Ammonium- oder Phosphoniumsalze durchführt.

## Claims (Claims for the following Contracting State(s): AT, BE, CH, DE, FR, GB, IT, LI, NL)

1. A cyclic acylphosphinic acid derivative of the formula 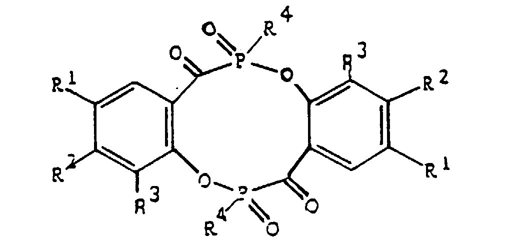 in which the substituents independently of each other have the following meanings:
R¹, R², R³ = H, halogen, C1- to C10-alkyl or -alkoxy, phenyl, phenoxy, acetyl or NO₂, where R¹ and R² together, with incorporation of the associated aromatic 6-ring, can also form an extended, unsubstituted or substituted aromatic ring system;
R⁴ = C1- to C4-alkyl, C5- or C6-cycloalkyl, phenyl or alkylphenyl.

2. The cyclic acylphosphinic acid derivative of the formula as claimed in claim 1, in which the substituents independently of each other have the following meanings:
R¹, R², R³ = H, Cl, Br, CH₃, CH₃O, CH₃CO or NO₂, where R¹ and R² together, with incorporation of the associated aromatic 6-ring, can also form a naphthalene structure which may be substituted by a methoxy group;
R⁴ = methyl, sec-butyl or phenyl.

3. A process for the preparation of the cyclic acylphosphinic acid derivative as claimed in claim 1 or 2, which comprises reacting aromatic o-hydroxycarboxylic acids of the formula 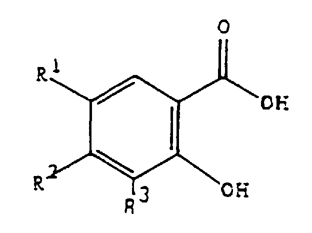 or their alkali metal salts with organodichlorophosphines of the formula R⁴PCl₂, where R¹, R², R³ and R⁴ have the meanings given, in an aprotic solvent or suspension medium at temperatures of 0 to 200°C, preferably 20 to 150°C, with elimination of gaseous hydrogen chloride or precipitation of alkali metal chloride and separating off, washing and drying the precipitated target product.

4. The process as claimed in claim 3, wherein the reaction is carried out in the presence of catalytic amounts of heterocyclic, aromatic compounds or quaternary ammonium or phosphonium salts.

## Claims (Claims for the following Contracting State(s): ES)

1. A process for the preparation of a cyclic acylphosphinic acid derivative of the formula 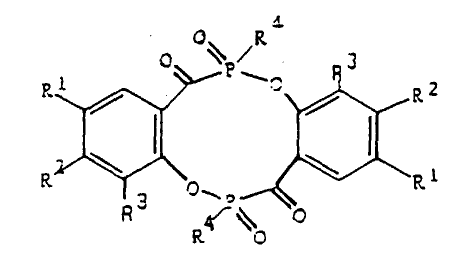 in which the substituents independently of each other have the following meanings:
R¹, R², R³ = H, halogen, C1- to C10-alkyl or -alkoxy, phenyl, phenoxy, acetyl or NO₂, where R¹ and R² together, with incorporation of the associated aromatic 6-ring, can also form an extended, unsubstituted or substituted aromatic ring system;
R⁴ = C1- to C4-alkyl, C5- or C6-cycloalkyl, phenyl or alkylphenyl; which comprises reacting aromatic o-hydroxycarboxylic acids of the formula 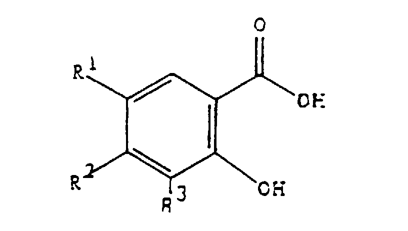 or their alkali metal salts with organodichlorophosphines of the formula R⁴PCl₂, where R¹, R², R³ and R⁴ have the meanings given, in an aprotic solvent or suspension medium at temperatures of 0 to 200°C, preferably 20 to 150°C, with elimination of gaseous hydrogen chloride or precipitation of alkali metal chloride and separating off, washing and drying the precipitated target product.

2. The process as claimed in claim 1, wherein the reaction is carried out in the presence of catalytic amounts of heterocyclic, aromatic compounds or quaternary ammonium or phosphonium salts.

## Revendications (Revendications pour l'(les) Etat(s) contractant(s) suivant(s): AT, BE, CH, DE, FR, GB, IT, LI, NL)

1. Dérivés cycliques d'acide acylphosphinique de formule 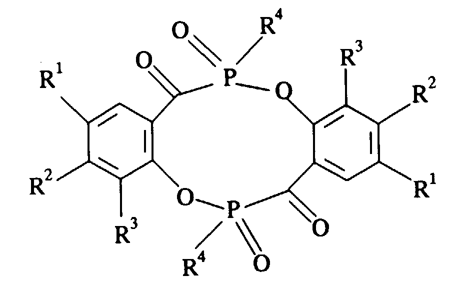 dans laquelle les substituants ont indépendamment les uns des autres la signification suivante :
R¹, R², R³ = H, halogène, alkyle ou alcoxy en C₁ à C₁₀, phényle, phénoxy, acétyle ou NO₂, R¹ et R² pouvant aussi former ensemble, en combinaison avec le cycle aromatique à 6 chaînons associé, un système cyclique aromatique élargi, éventuellement substitué ;
R⁴ = alkyle en C₁ à C₄, cycloalkyle en C₅ ou C₆, phényle ou alkylphényle.

2. Dérivés cycliques d'acide acylphosphinique de formule selon la revendication 1, où les substituants ont indépendamment les uns des autres la signification suivante :
R¹, R², R³ = H, Cl, Br, CH₃, CH₃O, CH₃CO ou NO₂, R¹ et R² pouvant aussi former ensemble, en combinaison avec le cycle aromatique à 6 chaînons associé, une structure naphtalène éventuellement substituée par un groupe méthoxy ;
R⁴ = méthyle, sec-butyle ou phényle.

3. Procédé de préparation des dérivés cycliques d'acide acylphosphinique selon la revendication 1 ou 2, caractérisé en ce que l'on fait réagir des acides o-hydroxycarboxyliques aromatiques de formule 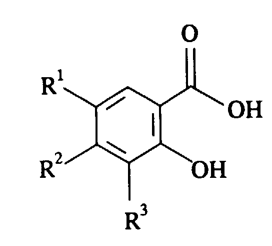 ou leurs sels alcalins avec des organyldichlorophosphanes de formule R⁴PCl₂, R¹, R², R³ et R⁴ possédant la signification indiquée, dans un solvant ou agent de suspension aprotique à des températures de 0 à 200°C, de préférence de 20 à 150°C, avec libération de chlorure d'hydrogène gazeux ou dépôt de chlorure alcalin, et on sépare, lave et sèche le produit recherché précipité.

4. Procédé selon la revendication 3, caractérisé en ce que l'on conduit la réaction en présence de quantités catalytiques de composés aromatiques hétérocycliques ou de sels d'ammonium ou de phosphonium quaternaire.

## Revendications (Revendications pour l'(les) Etat(s) contractant(s) suivant(s): ES)

1. Procédé de préparation de dérivés cycliques d'acide acylphosphinique de formule 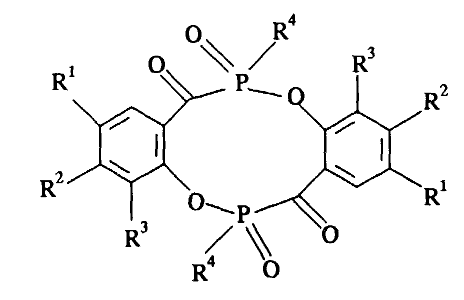 dans laquelle les substituants ont indépendamment les uns des autres la signification suivante :
R¹, R², R³ = H, halogène, alkyle ou alcoxy en C₁ à C₁₀, phényle, phénoxy, acétyle ou NO₂, R¹ et R² pouvant aussi former ensemble, en combinaison avec le cycle aromatique à 6 chaînons associé, un système cyclique aromatique élargi, éventuellement substitué ;
R⁴ = alkyle en C₁ à C₄, cycloalkyle en C₅ ou C₆, phényle ou alkylphényle, caractérisé en ce que l'on fait réagir des acides o-hydroxycarboxyliques aromatiques de formule 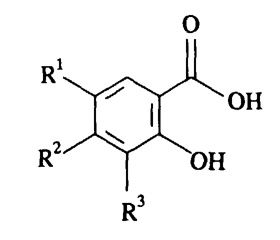 ou leurs sels alcalins avec des organyldichlorophosphanes de formule R⁴PCl₂, R¹, R², R³ et R⁴ possédant la signification indiquée, dans un solvant ou agent de suspension aprotique à des températures de 0 à 200°C, de préférence de 20 à 150°C, avec libération de chlorure d'hydrogène gazeux ou dépôt de chlorure alcalin, et on sépare, lave et sèche le produit recherché précipité.

2. Procédé selon la revendication 1, caractérisé en ce que l'on conduit la réaction en présence de quantités catalytiques de composés aromatiques hétérocycliques ou de sels d'ammonium ou de phosphonium quaternaire.
